(19) **Europäisches Patentamt**
**European Patent Office**
**Office européen des brevets**

(11) **EP 2 752 867 B1**

(12) **EUROPEAN PATENT SPECIFICATION**

(45) Date of publication and mention
of the grant of the patent:
**02.01.2019 Bulletin 2019/01**

(51) Int Cl.:
*C09J 7/38* (2018.01)          *H01L 21/027* (2006.01)
*B29C 59/02* (2006.01)

(21) Application number: **12827231.7**

(86) International application number:
**PCT/JP2012/071540**

(22) Date of filing: **27.08.2012**

(87) International publication number:
**WO 2013/031710 (07.03.2013 Gazette 2013/10)**

(54) **ADHESIVE SHEET FOR IMMOBILIZING IMPRINT MOLD, IMPRINT DEVICE, AND IMPRINT METHOD**

KLEBEFOLIE ZUR IMMOBILISIERUNG EINER PRÄGEFORM, PRÄGEVORRICHTUNG UND PRÄGEVERFAHREN

FEUILLE ADHÉSIVE PERMETTANT D'IMMOBILISER UN MOULE D'IMPRESSION, DISPOSITIF D'IMPRESSION ET PROCÉDÉ D'IMPRESSION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.08.2011 JP 2011189115**

(43) Date of publication of application:
**09.07.2014 Bulletin 2014/28**

(73) Proprietor: **Soken Chemical & Engineering Co., Ltd.**
**Toshima-ku**
**Tokyo 171-8531 (JP)**

(72) Inventors:
• **UEHARA, Satoshi**
  **Sayama-shi**
  **Saitama 350-1320 (JP)**
• **TAKAHASHI, Takanori**
  **Sayama-shi**
  **Saitama 350-1320 (JP)**

(74) Representative: **Dehns**
**St. Brides House**
**10 Salisbury Square**
**London EC4Y 8JD (GB)**

(56) References cited:
| | |
|---|---|
| WO-A1-00/17284 | WO-A1-2011/004818 |
| WO-A1-2011/016148 | WO-A1-2011/016148 |
| JP-A- 2010 270 188 | JP-A- 2011 001 520 |
| US-A1- 2004 241 434 | US-B1- 6 398 892 |

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical Field

The present invention relates to a pressure-sensitive adhesive double-coated sheet for immobilizing an imprint mold used for imprinting, an imprint apparatus and an imprint method using the pressure-sensitive adhesive sheet.

Background Art

In the production of semiconductors and optical devices, an operation called imprinting, which comprises pressing an imprint mold having a specific pattern profile against a thermoplastic resin or a thermosetting resin and heating it or irradiating it with ultraviolet rays to transfer the pattern profile to the resin, has been carried out in order to form a circuit structure or the like.

For the imprinting operation, an apparatus equipped with a pressure application unit for pressing the imprint mold against the resin is used, and in this apparatus, the imprint mold is immobilized onto the pressure application unit. It is known that as a means to hold them, a pressure-sensitive adhesive double-coated sheet is used. On the other hand, it is necessary in the imprinting operation to replace an imprint mold when the imprint mold is broken or when a semiconductor material or an optical device having a different pattern is produced, and therefore, the imprint apparatus preferably has a structure wherein the imprint mold can be removed from the pressure application unit. Accordingly, there has been desired a pressure-sensitive adhesive double-coated sheet which exhibits such an adhesive strength that the imprint mold does not peel off or shift from the pressure application unit in the imprinting operation but which can be removed from the pressure application unit without adhesive residue in the replacement of the imprint mold. However, with the passage of time after the pressure-sensitive adhesive is bonded to an adherend, increase in adhesive strength of the pressure-sensitive adhesive tends to occur, and it is difficult to secure removability.

It is known that as a pressure-sensitive adhesive sheet for solving such a problem, a pressure-sensitive adhesive tape having a pressure-sensitive adhesive layer containing a pressure-sensitive adhesive and a side chain crystalline polymer is used in order to hold the imprint mold, and when the imprint mold is replaced, the temperature of the pressure-sensitive adhesive sheet is raised to a temperature of not lower than Tg of the side chain crystalline polymer to lower the adhesive strength of the pressure-sensitive adhesive layer containing the side chain crystalline polymer, whereby the imprint mold is peeled off from the pressure application unit (see, for example, patent literature 1).

In the photo imprinting wherein ultraviolet irradiation is carried out, however, the radiation heat from the light source reaches a maximum temperature of about 80°C. Therefore, if the imprint mold is held by the use of a pressure-sensitive adhesive tape whose adhesive strength is lowered by heat, there is a possibility of peeling of the imprint mold from the pressure application unit during the imprinting operation. Particularly when a roll type pressure application unit is used as the pressure application unit, it is necessary to take into consideration heat reserve of the radiation heat of the roll.

Similar disclosure of pressure-sensitive adhesive tapes is found in patent literature documents 2-4.

Accordingly, a pressure-sensitive adhesive tape whose adhesive strength is not lowered even in the presence of heat generated in the imprinting operation and which facilitates replacement of an imprint mold has been desired.

Citation List

Patent Literature

Patent literature 1: JP 2011/001520 A1 (Japanese Patent Laid-Open Publication No. 2011-1520)
Patent literature 2: WO 00/17284 A1
Patent literature 3: US 6 398 892 B1
Patent literature 4: US 2004/241434 A1

Summary of Invention

Technical Problem

It is an object of the present invention to provide a pressure-sensitive adhesive sheet for immobilization of an imprint mold, which is a pressure-sensitive adhesive sheet capable of immobilizing an imprint mold so that the imprint mold should not peel off or shift during imprinting and which can be peeled off from a pressure application unit of an imprint apparatus when the imprint mold is replaced.

Solution to Problem

The present invention relates to the following [1] to [10].

[1] A pressure-sensitive adhesive sheet for immobilization of an imprint mold, which is a pressure-sensitive adhesive sheet used for integrally immobilizing an imprint mold to a pressure application unit in an imprint apparatus for transferring a profile of a fine pattern formed on the imprint mold to a transfer-receiving body by pressing the imprint mold having the fine pattern thereon against the transfer-receiving body,
said pressure-sensitive adhesive sheet having a substrate, a pressure-sensitive adhesive layer (A) provided on one surface of the substrate and a pressure-sensitive adhesive layer (B) provided on the other surface of the substrate, wherein the pressure-sensitive adhesive layer (A) is used for being bonded to the pressure application unit of the imprint apparatus, and the pressure-sensitive adhesive layer (B) is used for being bonded to the imprint mold, the adhesive strength of the pressure-sensitive adhesive layer (B) at 23°C is higher than the adhesive strength of the pressure-sensitive adhesive layer (A) at 23°C, and
the pressure-sensitive adhesive layer (A) has an adhesive strength of 1 to 10 N/25 mm at 23°C and an adhesive strength of 1 to 30 N/25 mm after allowed to stand for 7 hours at 80°C and a humidity of 65%, and the pressure-sensitive adhesive layer (B) has an adhesive strength of 3 to 30 N/25 mm at 23°C, wherein said pressure-sensitive adhesive sheet satisfies at least one of following (1)-(5) requirements:

(1) the pressure-sensitiveadhesive layer (B) contains a light absorber and/or a light stabilizer,
(2) the weight-average molecular weight of the polymer constituting the pressure-sensitive adhesive in the pressure-sensitive adhesive layer (A) is 800,000 to 1,800,000,
(3) the pressure-sensitive adhesive in the pressure-sensitive adhesive layer (A) is an acrylic/silicone-based copolymer obtained by copolymerizing monomers containing 0.5 to 20 parts by weight of a silicone-containing monomer based on 100 parts by weight of all the monomers,
(4) the gel fraction of the pressure-sensitive adhesive layer (A) is 70 to 95%, and
(5) the pressure-sensitive adhesive layer (A) contains 1 to 20 parts by weight of silicone oil based on 100 parts by weight of the pressure-sensitive adhesive.

[2] The pressure-sensitive adhesive sheet for immobilization of an imprint mold as stated in [1], which is used in an imprint apparatus wherein the pressure applied to the imprint mold during imprinting is 0.1 to 50 MPa.
[3] The pressure-sensitive adhesive sheet for immobilization of an imprint mold as stated in [1] or [2], which is used in a roll type imprint apparatus.
[4] The pressure-sensitive adhesive sheet for immobilization of an imprint mold as stated in any one [1] to [3], which is used for integrally immobilizing an imprint mold having a pattern of a size of nanometer order formed thereon to the pressure application unit.
[5] The pressure-sensitive adhesive sheet for immobilization of an imprint mold as stated in any one of [1] to [4], wherein the adhesive strength of a pressure-sensitive adhesive in the pressure-sensitive adhesive layer (A) is 1 to 10 N/25 mm.
[6] The pressure-sensitive adhesive sheet for immobilization of an imprint mold as stated in [5], wherein the pressure-sensitive adhesive in the pressure-sensitive adhesive layer (A) is an acrylic copolymer obtained by copolymerizing a (meth) acrylic monomer and a monomer having a crosslinking functional group.
[7] An imprint apparatus for transferring a profile of a fine pattern formed on an imprint mold to a transfer-receiving body by pressing the imprint mold having the fine pattern thereon against the transfer-receiving body, wherein:
when the imprint mold which comes into direct contact with the transfer-receiving body is integrally immobilized to a pressure application unit, on which a pressure is applied, with the pressure-sensitive adhesive sheet for immobilization of an imprint mold as stated in any one of [1] to [6], the pressure-sensitive adhesive layer (B) is positioned on the imprint mold side of the substrate of the pressure-sensitive adhesive sheet, and the pressure-sensitive adhesive layer (A) is positioned on the pressure application unit side of the substrate thereof.
[8] The imprint apparatus as stated in [7], wherein the pressure application unit is a roll type pressure application unit.
[9] A method for immobilizing an imprint mold to an imprint apparatus, comprising bonding the pressure-sensitive adhesive layer (A) of the pressure-sensitive adhesive sheet for immobilization of an imprint mold as stated in any one of [1] to [6] to a pressure application unit and bonding an imprint mold to the pressure-sensitive adhesive layer (B) of the pressure-sensitive adhesive sheet for immobilization of an imprint mold.
[10] A method for removing an imprint mold from an imprint apparatus, comprising peeling off the pressure-sensitive adhesive layer (A) of the pressure-sensitive adhesive sheet for immobilization of an imprint mold as stated in any one of [1] to [6] from a pressure application unit.

Advantageous Effects of Invention

The pressure-sensitive adhesive sheet for immobilization of an imprint mold of the present invention is capable of immobilizing an imprint mold so that the imprint mold should not peel off or shift during imprinting, and it also has durability. Further, when the imprint mold is replaced, the pressure-sensitive adhesive sheet can be peeled off from the pressure application unit of the imprint apparatus without adhesive residue.

Brief Description of Drawing

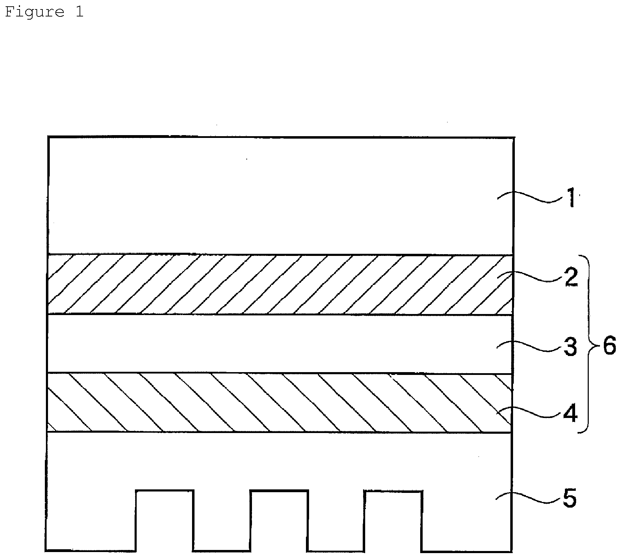

Fig. 1 is a partial schematic view of an imprint apparatus using the pressure-sensitive adhesive sheet for immobilization of an imprint mold of the present invention.

Description of Embodiments

The present invention will be specifically described below.
The present invention is a pressure-sensitive adhesive sheet for immobilization of an imprint mold, which is a pressure-sensitive adhesive sheet used for integrally immobilizing an imprint mold to a pressure application unit in an imprint apparatus for transferring a profile of a fine pattern formed on the imprint mold to a transfer-receiving body by pressing the imprint mold having the fine pattern thereon against the transfer-receiving body,
said pressure-sensitive adhesive sheet having a substrate, a pressure-sensitive adhesive layer (A) provided on one surface of the substrate and a pressure-sensitive adhesive layer (B) provided on the other surface of the substrate, wherein the pressure-sensitive adhesive layer (A) is used for being bonded to the pressure application unit of the imprint apparatus, and the pressure-sensitive adhesive layer (B) is used for being bonded to the imprint mold, the adhesive strength of the pressure-sensitive adhesive layer (B) at 23°C is higher than the adhesive strength of the pressure-sensitive adhesive layer (A) at 23°C, and
the pressure-sensitive adhesive layer (A) has an adhesive strength of 1 to 10 N/25 mm at 23°C and an adhesive strength of 1 to 30 N/25 mm after allowed to stand for 7 hours at 80°C and a humidity of 65%, and the pressure-sensitive adhesive layer (B) has an adhesive strength of 3 to 30 N/25 mm at 23°C.
In this specification, (meth)acrylate indicates acrylate and/or methacrylate.
The pressure-sensitive adhesive sheet for immobilization of an imprint mold of the present invention can be used in a usual imprint apparatus, and is used for immobilizing an imprint mold to a pressure application unit of an imprint apparatus wherein the pressure applied to the imprint mold during imprinting is preferably 0.1 to 50 MPa, more preferably 2 to 30 MPa. The imprint mold does not peel off from the pressure application unit during imprinting even if the above pressure is applied.
The pressure-sensitive adhesive sheet for immobilization of an imprint mold of the present invention is preferably used for immobilizing an imprint mold having a pattern of a size of nanometer order formed thereon to a pressure application unit of an imprint apparatus. The pattern of a size of nanometer order means a depression-protrusion pattern preferably having a constant pitch of 10 nm to 50 $\mu$m, having a height of 50 nm to 1,000 nm and having a shape of line, column, monolith, circular cone, polygonal pyramid, micro lens or the like.
The pressure-sensitive adhesive sheet for immobilization of an imprint mold of the present invention can be used for immobilizing an imprint mold to a pressure application unit of any of a pedestal type imprint apparatus and a roll type imprint apparatus, but the pressure-sensitive adhesive sheet is preferably used for immobilizing an imprint mold to a pressure application unit of a roll type imprint apparatus because it can be used even in the presence of radiation heat.
The reason why the adhesive strength of the pressure-sensitive adhesive layer (A) bonded to the pressure application unit is made lower than the adhesive strength of the pressure-sensitive adhesive layer (B) bonded to the imprint mold is that when imprinting is performed, the pressure-sensitive adhesive sheet needs to be strongly bonded to the imprint mold on which a pressure is applied, but when the pressure-sensitive adhesive sheet is bonded to the pressure application unit, it needs to have removability.

(1) Pressure-sensitive adhesive layer (A)

The pressure-sensitive adhesive layer (A) is used for being bonded to a pressure application unit of an imprint apparatus.
The adhesive strength of the pressure-sensitive adhesive layer (A) at 23°C is 1 to 10 N/25 mm, and the adhesive strength thereof at 23°C is preferably 2 to 8 N/25 mm. By allowing the adhesive strength to be in the above range, the pressure-sensitive adhesive layer can exhibit imprint mold immobilization power so that the imprint mold should not peel off or should not shift even in the imprinting operation wherein a pressure of 0.1 to 50 MPa is applied to the imprint mold. By allowing the adhesive strength at the above temperature to be in the above range, further, the adhesive strength of the pressure-sensitive adhesive layer (A) does not become a value by which immobilization of an imprint mold is made impossible during imprinting, even in the presence of radiation heat from a light source, said radiation having a maximum temperature of 80°C in the photo imprinting.

Furthermore, the pressure-sensitive adhesive layer (A) has removability, and the adhesive strength (also referred to as "peel strength") of the pressure-sensitive adhesive layer (A) after the layer is allowed to stand for 7 hours at 80°C and a humidity of 65% is 1 to 30 N/25 mm, preferably 2 to 20 N/25 mm, more preferably 3 to 15 N/25 mm. When the peel strength is in the above range, it is possible to remove the imprint mold from the pressure application unit without adhesive residue in the replacement of the imprint mold.

In order to allow the pressure-sensitive adhesive layer (A) to have an adhesive strength and a peel strength of the above ranges at the above temperatures, there can be used:

(i) a method of using a pressure-sensitive adhesive having a low adhesive strength as a pressure-sensitive adhesive used for the pressure-sensitive adhesive layer (A),
(ii) a method of controlling a weight-average molecular weight of a pressure-sensitive adhesive used for the pressure-sensitive adhesive layer (A),
(iii) a method of using an acrylic/silicone-based copolymer as a pressure-sensitive adhesive used for the pressure-sensitive adhesive layer (A),
(iv) a method of controlling a gel fraction of the pressure-sensitive adhesive layer (A), and
(v) a method of incorporating silicone oil into the pressure-sensitive adhesive layer (A).

These methods may be carried out singly or in combination.

(i) Method of using pressure-sensitive adhesive having low adhesive strength as pressure-sensitive adhesive used for the pressure-sensitive adhesive layer (A)

By using a pressure-sensitive adhesive having a low adhesive strength as a pressure-sensitive adhesive used for the pressure-sensitive adhesive layer (A), the adhesive strength and the peel strength of the pressure-sensitive adhesive layer (A) can be adjusted to the above ranges. The pressure-sensitive adhesive having a low adhesive strength means a pressure-sensitive adhesive having an adhesive strength of 1 to 10 N/25 mm.

As the pressure-sensitive adhesive having a low adhesive strength, a pressure-sensitive adhesive that is generally on the market as a removable pressure-sensitive adhesive can be mentioned, and examples thereof include acrylic polymers obtained by copolymerizing (meth)acrylic monomers, such as butyl (meth)acrylate, 2-ethylhexyl (meth)acrylate, isooctyl (meth)acrylate and benzyl (meth)acrylate, with monomers having crosslinking functional groups such as carboxyl group, hydroxyl group, amino group and amide group. The weight-average molecular weight of the polymers is usually 200,000 to 800,000. Examples of commercial products of such pressure-sensitive adhesives include SK Dyne 1473H and SK Dyne 1439U available from Soken Chemical & Engineering Co., Ltd.

(ii) Method of controlling weight-average molecular weight of pressure-sensitive adhesive used for the pressure-sensitive adhesive layer (A)

By controlling the weight-average molecular weight of the pressure-sensitive adhesive to 800,000 to 1,800,000, preferably 1,000,000 to 1,500,000, the adhesive strength and the peel strength of the pressure-sensitive adhesive layer (A) can be adjusted to the above ranges.

In order to obtain such a weight-average molecular weight, there can be used, for example, a method of adjusting the amount of an initiator to more than 0.01 part by weight but not less than or equal to 0.1 part by weight based of 100 parts by weight of the pressure-sensitive adhesive.

(iii) Method of using acrylic/silicone-based copolymer as pressure-sensitive adhesive used for the pressure-sensitive adhesive layer (A)

By using an acrylic/silicone-based copolymer as a pressure-sensitive adhesive used for the pressure-sensitive adhesive layer (A), the adhesive strength and the peel strength of the pressure-sensitive adhesive layer (A) can be adjusted to the above ranges.

The acrylic/silicone-based copolymer can be obtained by copolymerizing 79.5 to 99 parts by weight of a monomer, such as butyl acrylate, 2-ethylhexyl acryalte, isooctyl acrylate or benzyl acrylate, 0.5 to 5 parts by weight of a monomer having a crosslinking functional group such as carboxyl group, hydroxyl group, amino group or amide group, and 0.5 to 20 parts by weight of a silicone-containing monomer, such as a silicone macromer (the total amount of all the monomers used for the polymerization is 100 parts by weight) . The molecular weight of the silicone macromer is preferably 600 to 10,000. The weight-average molecular weight of the acrylic/silicone-based copolymer is preferably 200,000 to 800,000.

Examples of commercial products of the silicone macromers include Silaplane FM-0711 (available from JNC Co., Ltd.) and X-22-174DX (available from Shin-Etsu Silicone Co., Ltd.).

(iv) Method of controlling gel fraction of the pressure-sensitive adhesive layer (A)

By controlling the gel fraction of the pressure-sensitive adhesive layer (A), the adhesive strength and the peel strength of the pressure-sensitive adhesive layer (A) can be adjusted to the above ranges.

As the pressure-sensitive adhesive, a publicly known pressure-sensitive adhesive, preferably an acrylic pressure-sensitive adhesive (e.g., SK Dyne 1882 available from Soken Chemical & Engineering Co., Ltd.), can be used.

The gel fraction of the pressure-sensitive adhesive layer (A) is preferably 70 to 95%, more preferably 80 to 90%. In order to control the gel fraction to a value of the above range, it is preferable to adjust the content of a curing agent to 0.1 to 5.0 parts by weight, preferably 0.5 to 2.5 parts by weight, based on 100 parts by weight of the pressure-sensitive adhesive of the pressure-sensitive adhesive layer (A). As the curing agent, an isocyanate-based curing agent, an epoxy-based curing agent or the like can be used. A curing accelerator may be further used, and the content of the curing accelerator is preferably 0.01 to 1.0 part by weight, more preferably 0.05 to 0.5 part by weight, based on 100 parts by weight of the pressure-sensitive adhesive of the pressure-sensitive adhesive layer (A). As the curing accelerator, a publicly known organotin compound (e.g., Neostan U-860 available from Nitto Kasei Co., Ltd.) can be used.

(v) Method of incorporating silicone oil into the pressure-sensitive adhesive layer (A)

By incorporating silicon oil into the pressure-sensitive adhesive layer (A), the adhesive strength and the peel strength of the pressure-sensitive adhesive layer (A) can be adjusted to the above ranges.

As the pressure-sensitive adhesive, a publicly known pressure-sensitive adhesive, preferably an acrylic pressure-sensitive adhesive (e.g., SK Dyne 1882 available from Soken Chemical & Engineering Co., Ltd.), can be used.

The silicone oil contained in the pressure-sensitive adhesive layer (A) is not specifically restricted, but silicone oil having compatibility with the pressure-sensitive adhesive is preferable. The content of the silicone oil in the pressure-sensitive adhesive layer (A) is preferably 1 to 20 parts by weight, more preferably 2 to 10 parts by weight, based on 100 parts by weight of the pressure-sensitive adhesive of the pressure-sensitive adhesive layer (A) .

Examples of commercial products of the silicone oils include KF-96L-0.65cs and KF-96L-1cs available from Shin-Etsu Silicone Co. Ltd. From the viewpoint of compatibility with the pressure-sensitive adhesive, KF-96L-0.65cs is preferable.

(2) Pressure-sensitive adhesive layer (B)

The pressure-sensitive adhesive layer (B) is used for being bonded to an imprint mold.

The adhesive strength of the pressure-sensitive adhesive layer (B) at 23°C is 3 to 30 N/25 mm, the adhesive strength thereof at 23°C is preferably 5 to 25 N, and the adhesive strength thereof at 23°C is more preferably 7 to 20 N.

As the pressure-sensitive adhesive component to constitute the pressure-sensitive adhesive layer (B), a usual acrylic pressure-sensitive adhesive or a usual rubber-based pressure-sensitive adhesive can be used. Examples of the acrylic pressure-sensitive adhesives include polymers obtained by copolymerizing monomers, such as butyl (meth) acrylate, 2-ethylhexyl (meth)acrylate, isooctyl (meth)acrylate and benzyl (meth)acrylate, with monomers having crosslinking functional groups such as carboxyl group, hydroxyl group, amino group and amide group. Examples of commercial products of such pressure-sensitive adhesives include SK Dyne 1882 and SK Dyne 1986H available from Soken Chemical & Engineering Co., Ltd.

The pressure-sensitive adhesive layer (B) preferably contains a light absorber and/or a light stabilizer from the viewpoint of prevention of brittleness of the pressure-sensitive adhesive layer (B) in the photo imprinting.

The light absorber is used preferably in an amount of 0.1 to 10 parts by weight, more preferably 1 to 5 parts by weight, based on 100 parts by weight of the pressure-sensitive adhesive, and the light stabilizer is used preferably in an amount of 0.1 to 10 parts by weight, more preferably 1 to 5 parts by weight, based on 100 parts by weight of the pressure-sensitive adhesive.

As the light absorber, a publicly known light absorber (e.g., TINUVIN 109 and TINUVIN 99-2 available from Ciba Inc.) can be used. As the light stabilizer, a publicly known light stabilizer (e.g., TINUVIN 123 and TINUVIN 144 available from Ciba Inc.) can be used.

(3) Substrate

As the substrate to constitute the pressure-sensitive adhesive sheet, a resin film, paper, a metal foil, cloth, nonwoven fabric or the like can be used.

Examples of the resin films include polyethylene film, polypropylene film, polybutene film, polybutadiene film, polymethylpentene film, polyvinyl chloride film, vinyl chloride copolymer film, polyethylene terephthalate film, polyethylene naphthalate film, polybutylene terephthalate film, polyurethane film, ethylene/vinyl acetate copolymer film, ionomer resin film, ethylene/ (meth) acrylic acid copolymer film, ethylene/ (meth) acrylic ester copolymer film, polystyrene film, polycarbonate film and polyimide film.

As the substrate for use in the present invention, a resin film is preferable from the viewpoint of handling property, and a polyethylene terephthalate film is more preferable from the viewpoints of heat resistance and material availability. The resin film may be subjected to a treatment for improving adhesion to the pressure-sensitive adhesive layer, such as corona treatment or plasma treatment.

(4) Pressure-sensitive adhesive sheet

The pressure-sensitive adhesive sheet of the present invention has the substrate, the pressure-sensitive adhesive layer (A) provided on one surface of the substrate and the pressure-sensitive adhesive layer (B) provided on the other surface of the substrate . The thickness of the pressure-sensitive adhesive layer (A) is usually 10 to 50 $\mu$m, preferably 15 to 40 $\mu$m. The thickness of the pressure-sensitive adhesive layer (B) is usually 10 to 50 $\mu$m, preferably 15 to 40 $\mu$m. The thickness of the substrate is usually 10 to 150 $\mu$m, preferably 10 to 100 $\mu$m.

In the pressure-sensitive adhesive sheet, the adhesive strength of the pressure-sensitive adhesive layer (A) at 23°C is lower than the adhesive strength of the pressure-sensitive adhesive layer (B) at 23°C. By making a difference in adhesive strength between the pressure-sensitive adhesive layers of the pressure-sensitive adhesive sheet and by using the pressure-sensitive adhesive layer (B) of higher adhesive strength for the purpose of being bonded to the imprint mold, the imprint mold can be immobilized so that the imprint mold should not be separated even by the pressure during imprinting, and moreover, by using the pressure-sensitive adhesive layer (A) of lower adhesive strength for the purpose of being bonded to the pressure application unit, the pressure-sensitive adhesive layer on the pressure application unit side can be easily peeled off, and replacement of the imprint mold can be carried out.

On the surface of the pressure-sensitive adhesive layer (A), which does not come into contact with the substrate, and on the surface of the pressure-sensitive adhesive layer (B), which does not come into contact with the substrate, a protective sheet may be laminated. The protective sheet is preferably a resin film having been subjected to a release treatment.

(5) Production process for pressure-sensitive adhesive sheet

Although the production process for the pressure-sensitive adhesive sheet is not specifically restricted, the production process can be carried out in the following manner.

All of the components to constitute the pressure-sensitive adhesive layer (A) are mixed, and the mixture is applied to one surface of the substrate by a publicly known method such as bar coating, comma coating or the like. Thereafter, the pressure-sensitive adhesive layer (A) is dried at a temperature of 50 to 120°C for 1 to 10 minutes. Next, to the substrate surface opposite to the surface where the pressure-sensitive adhesive layer is present, a mixture obtained by mixing all of the components to constitute the pressure-sensitive adhesive layer (B) is applied in the same manner as that for the pressure-sensitive adhesive layer (A). Thereafter, the pressure-sensitive adhesive layer (B) is dried at a temperature of 50 to 120°C for 1 to 10 minutes.

(6) Imprint apparatus

The imprint apparatus means an apparatus for transferring a profile of a fine pattern formed on an imprint mold to a transfer-receiving body by pressing the imprint mold having the fine pattern thereon against the transfer-receiving body.

In the imprint apparatus of the present invention, the imprint mold is immobilized to a pressure application unit with the pressure-sensitive adhesive sheet of the present invention. Specifically, when the imprint mold which comes into direct contact with the transfer-receiving body is integrally immobilized to the pressure application unit, on which a pressure is applied, with the pressure-sensitive adhesive sheet for immobilization of an imprint mold of the present invention in the imprint apparatus, the pressure-sensitive adhesive layer (B) is positioned on the imprint mold side of the substrate of the pressure-sensitive adhesive sheet, and the pressure-sensitive adhesive layer (A) is positioned on the pressure application unit side of the substrate thereof.

As the pressure application unit, a sheet type (pedestal type) pressure application unit and a roll type pressure application unit are available without any restriction, but a roll type pressure application unit ispreferable. In such a pressure-sensitive adhesive sheet, the pressure-sensitive adhesive layer that comes into contact with the pressure application unit has removability, and the pressure-sensitive adhesive that comes into contact with the imprint mold has high adhesive strength. Therefore, the imprint mold does not peel off from the pressure-sensitive adhesive sheet even by performing the imprinting operation wherein a high pressure is applied to the imprint mold, and the durability of the pressure-sensitive adhesive sheet is also excellent. On the other hand, when the imprint mold is replaced, the imprint mold can be removed from the pressure application unit because the pressure-sensitive adhesive layer (A) has removability.

The method for immobilizing the imprint mold to such an imprint apparatus is carried out by bonding the pressure-sensitive adhesive layer (A) of the pressure-sensitive adhesive sheet for immobilization of an imprint mold of the present invention to the pressure application unit and bonding the imprint mold to the pressure-sensitive adhesive layer (B) of the pressure-sensitive adhesive sheet for immobilization of an imprint mold. In the replacement of the imprint mold, the pressure-sensitive adhesive layer (A) of the pressure-sensitive adhesive sheet for immobilization of an imprint mold of the present invention is peeled off from the pressure application unit, whereby the imprint mold is removed from the imprint apparatus.

According to the method for immobilizing an imprint mold and the method for removing an imprint mold of the present invention, the imprint mold can be easily replaced when the imprint mold is, for example, broken.

Examples

The present invention will be described more specifically with reference to the following examples, but it should be construed that the present invention is in no way limited to those examples.

<Production of imprint apparatus>

With regard to each of the pressure-sensitive adhesive sheets for immobilization of imprint molds obtained in the examples and the comparative examples, any one of the pressure-sensitive adhesive layers (a-1) to (a-20) was laminated onto a resin imprint mold (pitch of pattern of mold used: 300 nm, height of pattern: 150 nm) using a transfer roller of 20 kg. Thus, resin imprint molds laminated with pressure-sensitive adhesive sheets for immobilization of imprint molds were obtained.

With regard to each of the resin imprint molds laminated with pressure-sensitive adhesive sheets for immobilization of imprint molds, the pressure-sensitive adhesive layer (b-1) or (b-2) of the pressure-sensitive adhesive sheet was laminated onto a roll surface of a roll (made of SUS, width: 250 mm) for roll imprinting using the transfer roller.

<Imprinting operation>

The roll of the imprint apparatus was pressed against a Lexan film (transfer region: width 210 mm, length 420 m) at 1.0 MPa, and the line was run in such a manner that the transfer resin PAK-02 (available from Toyo Gosei Co., Ltd.) could be uniformly applied (feed rate: 1m/sec, manufactured by Toshiba Machine Co., Ltd.) . Thereafter, while running the line, ultraviolet irradiation (50 mW/cm$^2$) was continuously carried out, and while curing the resin, continuous roll imprinting (roll surface temperature: 60 to 80°C, measured by infrared radiation thermometer AD-5617WP manufactured by A & D Co.) for 7 hours was carried out to obtain a molded film of 60 m. Thereafter, the resin imprint mold was removed from the roll.

Further, continuous roll imprinting for 14 hours was carried out in the same manner as above, and thereafter, the resin imprint mold was peeled off from the roll.

Numerical values of properties in the examples and the specification are values measured by the following measuring methods.

<Adhesive strength>

Adhesive strength at 23°C and adhesive strength after leaving for 7 hours at 80°C and a humidity of 65% were measured at a tensile angle of 90° and a peel rate of 300 mm/min in accordance with JIS Z0237.

<Weight-average molecular weight>

Using gel permeation chromatography (GPC), weight-average molecular weight (Mw) in terms of standard polystyrene was determined.

Measuring conditions

Apparatus: HLC-8120GPC (manufactured by Tosoh Corporation)

Column: the following five connected columns were used.

TSK-GEL HXL-H (guard column, available from Tosoh Corporation)
TSK-GEL G7000HXL (available from Tosoh Corporation)
TSK-GEL GMHXL (available from Tosoh Corporation)
TSK-GEL GMHXL (available from Tosoh Corporation) TSK-GEL G2500HXL (available from Tosoh Corporation)
Sample concentration: the sample was diluted with tetrahydrofuran so that the concentration might become 1.0 mg/cm$^3$.

Mobile phase solvent: tetrahydrofuran

Flow rate: 1.0 cm$^3$/min
Column temperature: 40°C

<Gel fraction>

About 0.1 g (sample weight) of the pressure-sensitive adhesive composition after aging for 7 days at 23°C was withdrawn in a sample bottle, then 30 cc of ethyl acetate was added, and the mixture was shaken for 4 hours. Thereafter, the contents of the sample bottle were filtered through a stainless steel wire cloth of 200 meshes, then the residues on the wire cloth were dried at 100°C for 2 hours, and the dry weight was measured. The gel fraction was determined by the following formula.

[Math. 1]

$$\text{Gel fraction (\%)} = (\text{dry weight of pressure-sensitive adhesive}$$
$$\text{composition/sample weight of pressure-sensitive adhesive}$$
$$\text{composition}) \times 100$$

<Peeling of imprint mold during roll imprinting>

Peeling of the imprint mold during the roll imprinting was visually observed, and evaluation was carried out based on the following criteria.
○: The resin imprint mold laminated with a pressure-sensitive adhesive sheet for immobilization of an imprint mold does not peel off from the roll during the imprinting operation.
×: The resin imprint mold laminated with a pressure-sensitive adhesive sheet for immobilization of an imprint mold peels off from the roll during the imprinting operation.

<Shifting of imprint mold during roll imprinting>

Shifting of the imprint mold during the roll imprinting was visually observed, and evaluation was carried out based on the following criteria.
○: The position of the resin imprint mold laminated with a pressure-sensitive adhesive sheet for immobilization of an imprint mold on the roll surface does not shift during the imprinting operation.
×: The position of the resin imprint mold laminated with a pressure-sensitive adhesive sheet for immobilization of an imprint mold on the roll surface shifts during the imprinting operation.

<Adhesive residue after roll imprinting>

Adhesive residue after roll imprinting was visually observed, and evaluation was carried out based on the following criteria.

○: When the resin imprint mold laminated with a pressure-sensitive adhesive sheet for immobilization of an imprint mold is peeled off from the roll after the imprinting operation, the pressure-sensitive adhesive does not remain on the roll surface.

×: When the resin imprint mold laminated with a pressure-sensitive adhesive sheet for immobilization of an imprint mold is peeled off from the roll after the imprinting operation, the pressure-sensitive adhesive remains on the roll surface.

<Durability>

After the 7-hour continuous roll imprinting and after the 14-hour continuous roll imprinting, the resin imprint mold laminated with a pressure-sensitive adhesive sheet for immobilization of an imprint mold was peeled off from the roll, and the condition of the pressure-sensitive adhesive layer having been in contact with the roll surface was visually observed, and evaluation was carried out based on the following criteria.

○: There is no change in the condition of the pressure-sensitive adhesive layer.

Δ: The pressure-sensitive adhesive layer becomes slightly brittle.

×: The pressure-sensitive adhesive layer becomes brittle.

[Example 1]

In a beaker, 100 g (amount of solid matter) of a pressure-sensitive adhesive (trade name: SK Dyne 1473H, available from Soken Chemical & Engineering Co., Ltd.) and 0.77 g (amount of solid matter) of an isocyanate-based curing agent (trade name: L-45, available from Soken Chemical & Engineering Co., Ltd.) were placed, then they were well mixed, and the mixture was applied onto a PET separator (trade name: MRF38, available from Mitsubishi Plastics, Inc.) and dried at 90°C for 3 minutes to produce a pressure-sensitive adhesive layer (a-1) . Likewise, in a beaker, 100 g (amount of solid matter) of a pressure-sensitive adhesive (trade name: SK Dyne 1882, available from Soken Chemical & Engineering Co., Ltd.), 0.55 g (amount of solid matter) of an isocyanate-based curing agent (L-45) and 0.016 g (amount of solid matter) of an epoxy-based curing agent (trade name: E-5XM, available from Soken Chemical & Engineering Co., Ltd.) were placed, then they were well mixed, and the mixture was applied onto a PET separator (MRF38) and dried at 90°C for 3 minutes to produce a pressure-sensitive adhesive layer (b-1). Thereafter, onto one surface of a PET film (Lumiler 60T38 available from Toray Industries, Inc.), the pressure-sensitive adhesive layer (a-1) was laminated, and onto the other surface, the pressure-sensitive adhesive layer (b-1) was laminated, whereby a pressure-sensitive adhesive sheet for immobilization of an imprint mold was prepared.

Using the pressure-sensitive adhesive sheet for immobilization of an imprint mold, the aforesaid imprinting operation was carried out, and as a result, troubles such as peeling of the resin imprint mold were not observed. After continuous imprinting for 14 hours, the resin imprint mold was peeled off from the roll, and as a result, the pressure-sensitive adhesive on the back surface became ragged. However, staining such as transfer of the pressure-sensitive adhesive to the roll was not observed.

[Example 2]

In a beaker, 100 g (amount of solid matter) of a pressure-sensitive adhesive (trade name: SK Dyne 1473H) and 0.77 g (amount of solid matter) of an isocyanate-based curing agent (L-45) were placed, then they were well mixed, and the mixture was applied onto a PET separator (MRF38) and dried at 90°C for 3 minutes to produce a pressure-sensitive adhesive layer (a-2). Likewise, in a beaker, 100 g (amount of solid matter) of a pressure-sensitive adhesive (SK Dyne 1882), 0.55 g (amount of solid matter) of an isocyanate-based curing agent (L-45), 0.016g (amount of solid matter) of an epoxy-based curing agent (E-5XM), 3.0 g (amount of solidmatter) of a light absorber (trade name: TINUVIN 109, available from Ciba Inc.) and 3.0 g (amount of solid matter) of a light stabilizer (trade name: TINUVIN 123, available from Ciba Inc.) were placed, then they were well mixed, and the mixture was applied onto a PET separator (MRF38) and dried at 90°C for 3 minutes to produce a pressure-sensitive adhesive layer (b-2) . Thereafter, onto one surface of a PET film (Lumiler 60T38), the pressure-sensitive adhesive layer (a-2) was laminated, and onto the other surface, the pressure-sensitive adhesive layer (b-2) was laminated, whereby a pressure-sensitive adhesive sheet for immobilization of an imprint mold was prepared.

Using the pressure-sensitive adhesive sheet for immobilization of an imprint mold, the aforesaid imprinting operation was carried out. After the 14-hour continuous imprinting, the resin imprint mold was peeled off from the roll. As a result, the pressure-sensitive adhesive on the back surface was normal.

[Example 3]

In a beaker, 100 g (amount of solid matter) of a pressure-sensitive adhesive (SK Dyne 1882), 0.55 g (amount of solid matter) of an isocyanate-based curing agent (L-45) and 0.032 g (amount of solid matter) of an epoxy-based curing agent (E-5XM) were placed, then they were well mixed, and the mixture was applied onto a PET separator (MRF38) and dried at 90°C for 3 minutes to produce a pressure-sensitive adhesive layer (a-3). Thereafter, onto one surface of a PET film (Lumiler 60T38), the pressure-sensitive adhesive layer (a-3) was laminated, and onto the other surface, the pressure-sensitive adhesive layer (b-1) obtained in Example 1 was laminated, whereby a pressure-sensitive adhesive sheet for immobilization of an imprint mold was prepared.

[Example 4]

In a beaker, 100 g (amount of solid matter) of a pressure-sensitive adhesive (SK Dyne 1882), 0.55 g (amount of solid matter) of an isocyanate-based curing agent (L-45), 0.016 g (amount of solid matter) of an epoxy-based curing agent (E-5XM) and 0.1 g of dioctyltin bis (isooctyl thioglycolate) (trade name: Neostan U-860, available from Nitto Kasei Co., Ltd.) that is a curing accelerator were placed, then they were well mixed, and the mixture was applied onto a PET separator (MRF38) and dried at 90°C for 3 minutes to produce a pressure-sensitive adhesive layer (a-4). Thereafter, onto one surface of a PET film (Lumiler 60T38), the pressure-sensitive adhesive layer (a-4) was laminated, and onto the other surface, the pressure-sensitive adhesive layer (b-1) obtained in Example 1 was laminated, whereby a pressure-sensitive adhesive sheet for immobilization of an imprint mold was prepared.

[Example 5]

In a beaker, 100 g (amount of solid matter) of a pressure-sensitive adhesive (SK Dyne 1882), 0.55 g (amount of solid matter) of an isocyanate-based curing agent (L-45), 0.016 g (amount of solid matter) of an epoxy-based curing agent (E-5XM) and 5.0 g of silicone oil (trade name: KF-96-10cs, Shin-Etsu Silicone Co., Ltd.) were placed, then they were well mixed, and the mixture was applied onto a PET separator (MRF38) and dried at 90°C for 3 minutes to produce a pressure-sensitive adhesive layer (a-5). Thereafter, onto one surface of a PET film (Lumiler 60T38), the pressure-sensitive adhesive layer (a-5) was laminated, and onto the other surface, the pressure-sensitive adhesive layer (b-1) obtained in Example 1 was laminated, whereby a pressure-sensitive adhesive sheet for immobilization of an imprint mold was prepared.

[Example 6]

In a flask equipped with a stirring device, a nitrogen gas feed pipe, a thermometer and a reflux condenser, 96 parts by weight of butyl acrylate, 3.5 parts by weight of 2-hydroxyethyl acrylate, 0.5 part by weight of acrylic acid and 150 parts by weight of ethyl acetate were placed. Thereafter, while feeding nitrogen gas (0.3 l/min) to the flask, the temperature of the contents of the flask was set at 80°C, then 0.05 part by weight of an initiator dimethyl-2,2'-azobis(2-methyl propionate) (trade name: V-601, available from Wako Pure Chemical Industries, Ltd.) was added, and the contents were maintained at 70°C for 6.0 hours. Thereafter, feeding of nitrogen gas was stopped, then 150 parts by weight of ethyl acetate were added, and the temperature was lowered to terminate the reaction, whereby a pressure-sensitive adhesive 1882HH was obtained.

100 g (amount of solidmatter) of the pressure-sensitive adhesive 1882HH, 0.55 g (amount of solid matter) of an isocyanate-based curing agent (L-45) and 0.016 g (amount of solid matter) of an epoxy-based curing agent (E-5XM) were added, then they were well mixed, and the mixture was applied onto a PET separator (MRF38) and dried at 90°C for 3 minutes to produce a pressure-sensitive adhesive layer (a-6). Thereafter, onto one surface of a PET film (Lumiler 60T38), the pressure-sensitive adhesive layer (a-6) was laminated, and onto the other surface, the pressure-sensitive adhesive layer (b-1) obtained in Example 1 was laminated, whereby a pressure-sensitive adhesive sheet for immobilization of an imprint mold was prepared.

[Example 7]

In a flask equipped with a stirring device, a nitrogen gas feed pipe, a thermometer and a reflux condenser, 91 parts by weight of butyl acrylate, 3.5 parts by weight of 2-hydroxyethyl acrylate, 0.5 part by weight of acrylic acid, 5 parts by weight of a silicone macromer (trade name: Silaplane FM-0711, molecular weight: 1000, available from JNC Co., Ltd.) and 150 parts by weight of ethyl acetate were placed. Thereafter, while feeding nitrogen gas (0.3 l/min) to the flask, the temperature of the contents of the flask was set at 80°C, then 0.05 part by weight of an initiator (V-601) was added, and the contents were maintained at 70°C for 6 hours. Thereafter, feeding of nitrogen gas was stopped, then 150 parts by weight of ethyl acetate were added, and the temperature was lowered to terminate the reaction, whereby a pressure-sensitive adhesive 1882Si was obtained.

100 g (amount of solidmatter) of the pressure-sensitive adhesive 1882Si, 0.55 g (amount of solid matter) of an isocyanate-based curing agent (L-45) and 0.016 g (amount of solid matter) of an epoxy-based curing agent (E-5XM) were added, then they were well mixed, and the mixture was applied onto a PET separator (MRF38) and dried at 90°C for 3 minutes to produce a pressure-sensitive adhesive layer (a-7). Thereafter, onto one surface of a PET film (Lumiler 60T38), the pressure-sensitive adhesive layer (a-7) was laminated, and onto the other surface, the pressure-sensitive adhesive layer (b-1) obtained in Example 1 was laminated, whereby a pressure-sensitive adhesive sheet for immobilization of an imprint mold was prepared.

[Example 8]

A pressure-sensitive adhesive layer (a-8) was produced by using SK Dyne 1439U (available from Soken Chemical & Engineering Co., Ltd.) instead of SK Dyne 1473H and using 0.15 g (amount of solid matter) of an epoxy-based curing agent (trade name: E-50C, available from Soken Chemical & Engineering Co. Ltd.) as the curing agent in Example 1. Thereafter, onto one surface of a PET film (Lumiler 60T38), the pressure-sensitive adhesive layer (a-8) was laminated, and onto the other surface, the pressure-sensitive adhesive layer (b-1) obtained in Example 1 was laminated, whereby a pressure-sensitive adhesive sheet for immobilization of an imprint mold was prepared.

[Example 9]

A pressure-sensitive adhesive layer (a-9) was produced by using SK Dyne 1676 (available from Soken Chemical & Engineering Co., Ltd.) instead of SK Dyne 1473H and changing the amount of the curing agent (L-45) to 1.2 g (amount of solid matter) in Example 1. Thereafter, onto one surface of a PET film (Lumiler 60T38), the pressure-sensitive adhesive layer (a-9) was laminated, and onto the other surface, the pressure-sensitive adhesive layer (b-1) obtained in Example 1 was laminated, whereby a pressure-sensitive adhesive sheet for immobilization of an imprint mold was prepared.

[Comparative Example 1]

A pressure-sensitive adhesive layer (a-10) was produced in the same manner as in the production process for the pressure-sensitive adhesive layer (a-1) in Example 1, except that the amount of the isocyanate-based curing agent (L-45) was changed to 6.50 g (amount of solid matter) . Thereafter, onto one surface of a PET film (Lumiler 60T38), the pressure-sensitive adhesive layer (a-10) was laminated, and onto the other surface, the pressure-sensitive adhesive layer (b-1) obtained in Example 1 was laminated, whereby apressure-sensitive adhesive sheet for immobilization of an imprint mold was prepared.
Using the pressure-sensitive adhesive sheet for immobilization of an imprint mold, the aforesaid imprinting operation was carried out. As a result, the adhesive strength of the pressure-sensitive adhesive layer (a-10) was insufficient, and about 1 hour after the beginning of roll imprinting, peeling was observed.

[Comparative Example 2]

A pressure-sensitive adhesive layer (a-11) was produced in the same manner as in the production process for the pressure-sensitive adhesive layer (a-1) in Example 1, except that the amount of the isocyanate-based curing agent (L-45) was changed to 0.05 g (amount of solid matter) . Thereafter, onto one surface of a PET film (Lumiler 60T38), the pressure-sensitive adhesive layer (a-11) was laminated, and onto the other surface, the pressure-sensitive adhesive layer (b-1) obtained in Example 1 was laminated, whereby apressure-sensitive adhesive sheet for immobilization of an imprint mold was prepared.
Using the pressure-sensitive adhesive sheet for immobilization of an imprint mold, the aforesaid roll imprinting operation for 14 hours was carried out. As a result, the adhesive strength of the pressure-sensitive adhesive layer (a-11) was too high, and when the imprint mold was peeled off from the roll, the pressure-sensitive adhesive remained on the roll.

[Comparative Example 3]

A pressure-sensitive adhesive 1882HH-2 was produced in the same manner as in the production process for the pressure-sensitive adhesive 1882HH in Example 6, except that the amount of the initiator (V-601) was changed to 0.5 part by weight. Then, a pressure-sensitive adhesive layer (a-12) was produced in the same manner as in the production process for the pressure-sensitive adhesive layer (a-6) in Example 6, except that the pressure-sensitive adhesive 1882HH-2 was used instead of the pressure-sensitive adhesive 1882HH. Thereafter, onto one surface of a PET film (Lumiler 60T38), the pressure-sensitive adhesive layer (a-12) was laminated, and onto the other surface, the pressure-sensitive adhesive layer (b-1) obtained in Example 1 was laminated, whereby a pressure-sensitive adhesive sheet for immobilization of an imprint mold was prepared.

Using the pressure-sensitive adhesive sheet for immobilization of an imprint mold, the aforesaid roll imprinting operation for 14 hours was carried out. As a result, the adhesive strength of the pressure-sensitive adhesive layer (a-12) was too high, and when the imprint mold was peeled off from the roll, the pressure-sensitive adhesive remained on the roll.

[Comparative Example 4]

A pressure-sensitive adhesive layer (a-13) was produced in the same manner as in the production process for the pressure-sensitive adhesive layer (a-4) in Example 4, except that the amount of the curing accelerator (U-860) added was changed to 5.0 g. Thereafter, onto one surface of a PET film (Lumiler 60T38), the pressure-sensitive adhesive layer (a-13) was laminated, and onto the other surface, the pressure-sensitive adhesive layer (b-1) obtained in Example 1 was laminated, whereby a pressure-sensitive adhesive sheet for immobilization of an imprint mold was prepared.

Using the pressure-sensitive adhesive sheet for immobilization of an imprint mold, the aforesaid imprinting operation was carried out. As a result, the adhesive strength of the pressure-sensitive adhesive layer (a-13) was insufficient, and about 1 hour after the beginning of roll imprinting, peeling was observed.

[Comparative Example 5]

A pressure-sensitive adhesive layer (a-14) was produced in the same manner as in the production process for the pressure-sensitive adhesive layer (a-4) in Example 4, except that the amount of the curing accelerator (U-860) added was changed to 0.005 g. Thereafter, onto one surface of a PET film (Lumiler 60T38), the pressure-sensitive adhesive layer (a-14) was laminated, and onto the other surface, the pressure-sensitive adhesive layer (b-1) obtained in Example 1 was laminated, whereby a pressure-sensitive adhesive sheet for immobilization of an imprint mold was prepared.

Using the pressure-sensitive adhesive sheet for immobilization of an imprint mold, the aforesaid roll imprinting operation for 14 hours was carried out. As a result, the adhesive strength of the pressure-sensitive adhesive layer (a-14) was too high, and the imprint mold could not be removed from the roll.

[Comparative Example 6]

A pressure-sensitive adhesive layer (a-15) was produced in the same manner as in the production process for the pressure-sensitive adhesive layer (a-5) in Example 5, except that the amount of the silicone oil (KF-96-10cs) added was changed to 25.0 g. Thereafter, onto one surface of a PET film (Lumiler 60T38), the pressure-sensitive adhesive layer (a-15) was laminated, and onto the other surface, the pressure-sensitive adhesive layer (b-1) obtained in Example 1 was laminated, whereby a pressure-sensitive adhesive sheet for immobilization of an imprint mold was prepared.

Using the pressure-sensitive adhesive sheet for immobilization of an imprint mold, the aforesaid imprinting operation was carried out. As a result, the adhesive strength of the pressure-sensitive adhesive layer (a-15) was insufficient, and about 1 hour after the beginning of roll imprinting, peeling was observed.

[Comparative Example 7]

A pressure-sensitive adhesive layer (a-16) was produced in the same manner as in the production process for the pressure-sensitive adhesive layer (a-5) in Example 5, except that the amount of the silicone oil (KF-96-10cs) added was changed to 0.94 g. Thereafter, onto one surface of a PET film (Lumiler 60T38), the pressure-sensitive adhesive layer (a-16) was laminated, and onto the other surface, the pressure-sensitive adhesive layer (b-1) obtained in Example 1 was laminated, whereby a pressure-sensitive adhesive sheet for immobilization of an imprint mold was prepared.

Using the pressure-sensitive adhesive sheet for immobilization of an imprint mold, the aforesaid roll imprinting operation for 14 hours was carried out. As a result, the adhesive strength of the pressure-sensitive adhesive layer (a-16) was too high, and when the imprint mold was peeled off from the roll, the pressure-sensitive adhesive remained on the roll.

[Comparative Example 8]

A pressure-sensitive adhesive 1882HH-3 was produced in the same manner as in the production process for the pressure-sensitive adhesive 1882HH in Example 6, except that the amount of the initiator (V-601) was changed to 0.01 part by weight. Then, a pressure-sensitive adhesive layer (a-17) was produced in the same manner as in the production process for the pressure-sensitive adhesive layer (a-6) in Example 6, except that the pressure-sensitive adhesive 1882HH-3 was used instead of the pressure-sensitive adhesive 1882HH. Thereafter, onto one surface of a PET film (Lumiler 60T38), the pressure-sensitive adhesive layer (a-17) was laminated, and onto the other surface, the pressure-sensitive adhesive layer (b-1) obtained in Example 1 was laminated, whereby a pressure-sensitive adhesive sheet for immobilization of an imprint mold was prepared.

Using the pressure-sensitive adhesive sheet for immobilization of an imprint mold, the aforesaid imprinting operation was carried out. As a result, the adhesive strength of the pressure-sensitive adhesive layer (a-17) was insufficient, and about 1 hour after the beginning of roll imprinting, peeling was observed.

[Comparative Example 9]

In a flask equipped with a stirring device, a nitrogen gas feed pipe, a thermometer and a reflux condenser, 66 parts by weight of butyl acrylate, 3.5 parts by weight of 2-hydroxyethyl acrylate, 0.5 part by weight of acrylic acid, 30 parts by weight of a silicone macromer (FM-0711) and 150 parts by weight of ethyl acetate were placed. Thereafter, while feeding nitrogen gas (0.3 l/min) to the flask, the temperature of the contents of the flask was set at 80°C, then 0.05 part by weight of an initiator (V-601) was added, and the contents were maintained at 70°C for 6 hours. Thereafter, feeding of nitrogen gas was stopped, then 150 parts by weight of ethyl acetate were added, and the temperature was lowered to terminate the reaction, whereby a pressure-sensitive adhesive 1882SiH was obtained.

A pressure-sensitive adhesive layer (a-18) was produced in the same manner as in the production process for the pressure-sensitive adhesive layer (a-6) in Example 6, except that the pressure-sensitive adhesive 1882SiH was used instead of the pressure-sensitive adhesive 1882HH. Thereafter, onto one surface of a PET film (Lumiler 60T38), the pressure-sensitive adhesive layer (a-18) was laminated, and onto the other surface, the pressure-sensitive adhesive layer (b-1) obtained in Example 1 was laminated, whereby a pressure-sensitive adhesive sheet for immobilization of an imprint mold was prepared.

Using the pressure-sensitive adhesive sheet for immobilization of an imprint mold, the aforesaid imprinting operation was carried out. As a result, the adhesive strength of the pressure-sensitive adhesive layer (a-18) was insufficient, and about 1 hour after the beginning of roll imprinting, peeling was observed.

[Comparative Example 10]

In a flask equipped with a stirring device, a nitrogen gas feed pipe, a thermometer and a reflux condenser, 95.9 parts by weight of butyl acrylate, 3.5 parts by weight of 2-hydroxyethyl acrylate, 0.5 part by weight of acrylic acid, 0.1 part by weight of a silicone macromer (FM-0711) and 150 parts by weight of ethyl acetate were placed. Thereafter, while feeding nitrogen gas (0.3 l/min) to the flask, the temperature of the contents of the flask was set at 80°C, then 0.05 part by weight of an initiator (V-601) was added, and the contents were maintained at 70°C for 6 hours. Thereafter, feeding of nitrogen gas was stopped, then 150 parts by weight of ethyl acetate were added, and the temperature was lowered to terminate the reaction, whereby a pressure-sensitive adhesive 1882SiL was obtained.

A pressure-sensitive adhesive layer (a-19) was produced in the same manner as in the production process for the pressure-sensitive adhesive layer (a-6) in Example 6, except that the pressure-sensitive adhesive 1882SiL was used instead of the pressure-sensitive adhesive 1882HH. Thereafter, onto one surface of a PET film (Lumiler 60T38), the pressure-sensitive adhesive layer (a-19) was laminated, and onto the other surface, the pressure-sensitive adhesive layer (b-1) obtained in Example 1 was laminated, whereby a pressure-sensitive adhesive sheet for immobilization of an imprint mold was prepared.

Using the pressure-sensitive adhesive sheet for immobilization of an imprint mold, the aforesaid roll imprinting operation for 14 hours was carried out. As a result, the adhesive strength of the pressure-sensitive adhesive layer (a-19) was too high, and when the imprint mold was peeled off from the roll, the pressure-sensitive adhesive remained on the roll.

[Comparative Example 11]

A pressure-sensitive adhesive 1882SiLL was obtained in the same manner as in the production process for the pressure-sensitive adhesive 1882Si in Example 7, except that a long-chain type silicone macromer (trade name: X-22-2426, molecular weight: 13000, available from Shinetsu silicon Co.Ltd.) was used instead of the silicone macromer (trade name: Silaplane FM-0711, molecular weight: 1000, available from JNC Co., Ltd.).

A pressure-sensitive adhesive layer (a-20) was produced in the same manner as in the production process for the pressure-sensitive adhesive layer (a-7) in Example 7, except that the pressure-sensitive adhesive 1882SiLL was used instead of the pressure-sensitive adhesive 1882Si. Thereafter, onto one surface of a PET film (Lumiler 60T38), the pressure-sensitive adhesive layer (a-20) was laminated, and onto the other surface, the pressure-sensitive adhesive layer (b-1) obtained in Example 1 was laminated, whereby a pressure-sensitive adhesive sheet for immobilization of an imprint mold was prepared.

Using the pressure-sensitive adhesive sheet for immobilization of an imprint mold, the aforesaid roll imprinting operation was carried out. As a result, the adhesive strength of the pressure-sensitive adhesive layer (a-20) was insufficient, and about 1 hour after the beginning of roll imprinting, peeling was observed.

[Table 1]

Table 1

| | | | Ex. 1 | Ex. 2 | Ex. 3 | Ex. 4 | Ex. 5 | Ex. 6 | Ex. 7 | Ex. 8 | Ex. 9 |
|---|---|---|---|---|---|---|---|---|---|---|---|
| Pressure-sensitive adhesive layer (A) | Pressure-sensitive adhesive | Type | 1473H | 1473H | 1882 | 1882 | 1882 | 1882HH | 1882Si | 1439U | 1676 |
| | | Amount (g) | 100 | 100 | 100 | 100 | 100 | 100 | 100 | 100 | 100 |
| | Curing agent (g) | L-45 | 0.77 | 0.77 | 0.55 | 0.55 | 0.55 | 0.55 | 0.55 | - | 1.2 |
| | Curing agent (g) | E-5XM | - | - | 0.032 | 0.016 | 0.016 | 0.016 | 0.016 | - | - |
| | Curing agent (g) | E-50C | - | - | - | - | - | - | - | 0.15 | - |
| | Curing accelerator (g) | U-860 | - | - | - | 0.1 | - | - | - | - | - |
| | Silicone oil (g) | KF-96-10cs | - | - | - | - | 5.0 | - | - | - | - |
| | Silicone macromer | FM-0711 | - | - | - | - | - | - | 5 parts by weight | - | - |
| | Weight-average molecular weight | | 620,000 | 620,000 | 1,000,000 | 1,000,000 | 1,000,000 | 1,400,000 | 760,000 | 680,000 | 720,000 |
| | Gel fraction (%) | | 78 | 78 | 72 | 82 | 70 | 74 | 72 | 83 | 84 |
| | Adhesive strength at 23°C (N/25mm-width) | | 3.5 | 3.5 | 3.2 | 3.6 | 3.4 | 4.2 | 3.5 | 1.2 | 1.2 |
| | Adhesive strength after leaving for 7 hours at 80°C and humidity of 65% (N/25mm-width) | | 8.2 | 8.2 | 7.8 | 8.6 | 8.1 | 9.4 | 7.6 | 2.5 | 6.8 |

(continued)

| | | Ex. 1 | Ex. 2 | Ex. 3 | Ex. 4 | Ex. 5 | Ex. 6 | Ex. 7 | Ex. 8 | Ex. 9 |
|---|---|---|---|---|---|---|---|---|---|---|
| Pressure-sensitive adhesive layer (B) | Type of pressure-sensitive adhesive | 1882 | 1882 | 1882 | 1882 | 1882 | 1882 | 1882 | 1882 | 1882 |
| | Light absorber (TINUVIN 109) (g) | - | 3.0 | - | - | - | - | - | - | - |
| | Light stabilizer (TINUVIN 123) (g) | - | 3.0 | - | - | - | - | - | - | - |
| | Adhesive strength at 23°C (N/25mm-width) | 10.5 | 10.5 | 10.5 | 10.5 | 10.5 | 10.5 | 10.5 | 10.5 | 10.5 |
| Peeling of mold in roll imprinting | | ○ | ○ | ○ | ○ | ○ | ○ | ○ | ○ | ○ |
| Shifting of mold in roll imprinting | | ○ | ○ | ○ | ○ | ○ | ○ | ○ | ○ | ○ |
| Adhesive residue after roll imprinting | | ○ | ○ | ○ | ○ | ○ | ○ | ○ | ○ | ○ |
| Durability in 7-hour continuous roll imprinting | | ○ | ○ | ○ | ○ | ○ | ○ | ○ | ○ | ○ |
| Durability in 14-hour continuous roll imprinting | | Δ | ○ | Δ | Δ | Δ | Δ | Δ | Δ | Δ |

In the table, the mass is an amount of solid matter.
The amount of the silicone macromer is a value based on 100 parts by weight of all the monomers used for the polymerization for the pressure-sensitive adhesive.

[Table 2]

Table 2

| | | | Comp. Ex. 1 | Comp. Ex. 2 | Comp. Ex. 3 | Comp. Ex. 4 | Comp. Ex. 5 | Comp. Ex. 6 |
|---|---|---|---|---|---|---|---|---|
| Pressure-sensitive adhesive layer (A) | Pressure-sensitive adhesive | Type | 1473H | 1473H | 1882HH-2 | 1882 | 1882 | 1882 |
| | | Amount (g) | 100 | 100 | 100 | 100 | 100 | 100 |
| | Curing agent (g) | L-45 | 6.5 | 0.05 | 0.55 | 0.55 | 0.55 | 0.55 |
| | Curing agent (g) | E-5XM | - | - | 0.016 | 0.016 | 0.016 | 0.016 |
| | Curing accelerator (g) | U-860 | - | - | - | 5 | 0.005 | - |
| | Silicone oil (g) | KF-96-10cs | - | - | - | - | - | 25 |
| | Silicone macromer | FM-0711 | - | - | - | - | - | - |
| | Silicone macromer | X-22-2426 | - | - | - | - | - | - |
| | Weight-average molecular weight | | 620,000 | 650,000 | 1,000,000 | 1,000,000 | 1,000,000 | 1,000,000 |
| | Gel fraction (%) | | 98 | 45 | 88 | 96 | 54 | 82 |
| | Adhesive strength at 23°C (N/25mm-width) | | 0.4 | 12.5 | 13.4 | 0.6 | 11.8 | 0.3 |
| | Adhesive strength after leaving for 7 hours at 80°C and humidity of 65% (N/25mm-width) | | 0.7 | 33.2 | 35.8 | 0.8 | 32.7 | 0.6 |
| Pressure-sensitive adhesive layer (B) | Type of pressure-sensitive adhesive | | 1882 | 1882 | 1882 | 1882 | 1882 | 1882 |
| | Light absorber (TINUVIN 109) (g) | | - | - | - | - | - | - |
| | Light stabilizer (TINUVIN 123) (g) | | - | - | - | - | - | - |
| | Adhesive strength at 23°C (N/25mm-width) | | 10.5 | 10.5 | 10.5 | 10.5 | 10.5 | 10.5 |
| Peeling of mold in roll imprinting | | | × | ○ | ○ | × | ○ | × |
| Shifting of mold in roll imprinting | | | ○ | ○ | ○ | ○ | ○ | ○ |
| Adhesive residue after roll imprinting | | | ○ | × | × | ○ | × | ○ |
| Durability in 7-hour continuous roll imprinting | | | × | ○ | ○ | × | ○ | × |
| Durability in 14-hour continuous roll imprinting | | | × | △ | △ | × | △ | × |

In the table, the mass is an amount of solid matter.

The amount of the silicone macromer is a value based on 100 parts by weight of all the monomers used for the polymerization for the pressure-sensitive adhesive.

[Table 2] (continued)

Table 2

| | | | Comp. Ex. 7 | Comp. Ex. 8 | Comp. Ex. 9 | Comp. Ex. 10 | Comp. Ex. 11 |
|---|---|---|---|---|---|---|---|
| Pressure-sensitive adhesive layer (A) | Pressure-sensitive adhesive | Type | 1882 | 1882HH-3 | 1882SiH | 1882SiL | 1882SiLL |
| | | Amount (g) | 100 | 100 | 100 | 100 | 100 |
| | Curing agent (g) | L-45 | 0.55 | 0.55 | 0.55 | 0.55 | 0.55 |
| | Curing agent (g) | E-5XM | 0.016 | 0.016 | 0.016 | 0.016 | 0.016 |
| | Curing accelerator (g) | U-860 | - | - | - | - | - |
| | Silicone oil (g) | KF-96-10cs | 0.94 | - | - | - | - |
| | Silicone macromer | FM-0711 | - | - | 30 parts by weight | 0.1 part by weight | - |
| | Silicone macromer | X-22-2426 | - | - | - | - | 5 parts by weight |
| | Weight-average molecular weight | | 1,000,000 | 2,000,000 | 1,020,000 | 1,080,000 | 1,000,000 |
| | Gel fraction (%) | | 80 | 84 | 82 | 62 | 64 |
| | Adhesive strength at 23°C (N/25mm-width) | | 11.2 | 0.2 | 0.08 | 14.3 | 3.2 |
| | Adhesive strength after leaving for 7 hours at 80°C and humidity of 65% (N/25mm-width) | | 32.2 | 0.4 | 0.2 | 36.1 | 0.4 |
| Pressure-sensitive adhesive layer (B) | Type of pressure-sensitive adhesive | | 1882 | 1882 | 1882 | 1882 | 1882 |
| | Light absorber (TINUVIN 109) (g) | | - | - | - | - | - |
| | Light stabilizer (TINUVIN 123) (g) | | - | - | - | - | - |
| | Adhesive strength at 23°C (N/25mm-width) | | 10.5 | 10.5 | 10.5 | 10.5 | 10.5 |
| Peeling of mold in roll imprinting | | | ○ | × | × | ○ | ○ |
| Shifting of mold in roll imprinting | | | ○ | ○ | ○ | ○ | ○ |
| Adhesive residue after roll imprinting | | | × | ○ | ○ | × | × |
| Durability in 7-hour continuous roll imprinting | | | ○ | ○ | ○ | × | × |
| Durability in 14-hour continuous roll imprinting | | | △ | △ | △ | × | × |

EP 2 752 867 B1

Reference Signs List

1: pressure application unit
2: pressure-sensitive adhesive layer (A)
3: substrate
4: pressure-sensitive adhesive layer (B)
5: imprint mold
6: pressure-sensitive adhesive sheet for immobilization of imprint mold

**Claims**

1. A pressure-sensitive adhesive sheet for immobilization of an imprint mold (5), which is a pressure-sensitive adhesive sheet used for integrally immobilizing an imprint mold (5) to a pressure application unit in an imprint apparatus for transferring a profile of a fine pattern formed on the imprint mold (5) to a transfer-receiving body by pressing the imprint mold having the fine pattern thereon against the transfer-receiving body,
said pressure-sensitive adhesive sheet having a substrate (3), a pressure-sensitive adhesive layer (A) (2) provided on one surface of the substrate (3) and a pressure-sensitive adhesive layer (B) (4) provided on the other surface of the substrate (3),
wherein the pressure-sensitive adhesive layer (A) is used for being bonded to the pressure application unit of the imprint apparatus, and the pressure-sensitive adhesive layer (B) is used for being bonded to the imprint mold (5),
the adhesive strength of the pressure-sensitive adhesive layer (B) at 23°C is higher than the adhesive strength of the pressure-sensitive adhesive layer (A) at 23°C, and
the pressure-sensitive adhesive layer (A) has an adhesive strength of 1 to 10 N/25 mm at 23°C and an adhesive strength of 1 to 30 N/25 mm after allowed to stand for 7 hours at 80°C and a humidity of 65%, and the pressure-sensitive adhesive layer (B) has an adhesive strength of 3 to 30 N/25 mm at 230 °C, wherein adhesive strength at 23°C and adhesive strength after leaving for 7 hours at 80°C and a humidity of 65% were measured at a tensile angle of 90° and a peel rate of 300 mm/min in accordance with JIS Z0237,
wherein said pressure-sensitive adhesive sheet satisfies at least one of following (1)-(5) requirements:

(1) the pressure-sensitive adhesive layer (B) contains a light absorber and/or a light stabilizer,
(2) the weight-average molecular weight of the polymer constituting the pressure-sensitive adhesive in the pressure-sensitive adhesive layer (A) is 800,000 to 1,800,000,
(3) the pressure-sensitive adhesive in the pressure-sensitive adhesive layer (A) is an acrylic/silicone-based copolymer obtained by copolymerizing monomers containing 0.5 to 20 parts by weight of a silicone-containing monomer based on 100 parts by weight of all the monomers,
(4) the gel fraction of the pressure-sensitive adhesive layer (A) is 70 to 95%, and
(5) the pressure-sensitive adhesive layer (A) contains 1 to 20 parts by weight of silicone oil based on 100 parts by weight of the pressure-sensitive adhesive.

2. The pressure-sensitive adhesive sheet for immobilization of an imprint mold as claimed in claim 1, which is for use in an imprint apparatus wherein the pressure applied to the imprint mold during imprinting is 0.1 to 50 MPa.

3. The pressure-sensitive adhesive sheet for immobilization of an imprint mold as claimed in claim 1 or 2, which is for use in a roll type imprint apparatus.

4. The pressure-sensitive adhesive sheet for immobilization of an imprint mold as claimed in any one of claims 1 to 3, which is for integrally immobilizing an imprint mold having a pattern of a size of nanometer order formed thereon to the pressure application unit.

5. The pressure-sensitive adhesive sheet for immobilization of an imprint mold as claimed in any one of claims 1 to 4, wherein the adhesive strength of a pressure-sensitive adhesive in the pressure-sensitive adhesive layer (A) is 1 to 10 N/25 mm.

6. The pressure-sensitive adhesive sheet for immobilization of an imprint mold as claimed in claim 5, wherein the pressure-sensitive adhesive in the pressure-sensitive adhesive layer (A) is an acrylic copolymer obtained by copolymerizing a (meth) acrylic monomer and a monomer having a crosslinking functional group.

7. An imprint apparatus for transferring a profile of a fine pattern formed on an imprint mold (5) to a transfer-receiving body by pressing the imprint mold (5) having the fine pattern thereon against the transfer-receiving body, wherein:

when the imprint mold (5) which comes into direct contact with the transfer-receiving body is integrally immobilized to a pressure application unit, on which a pressure is applied, with the pressure-sensitive adhesive sheet for immobilization of an imprint mold as claimed in any one of claims 1 to 6, the pressure-sensitive adhesive layer (B) is positioned on the imprint mold side of the substrate of the pressure-sensitive adhesive sheet, and the pressure-sensitive adhesive layer (A) is positioned on the pressure application unit side of the substrate thereof.

8. The imprint apparatus as claimed in claim 7, wherein the pressure application unit is a roll type pressure application unit.

9. A method for immobilizing an imprint mold (5) to an imprint apparatus, comprising bonding the pressure-sensitive adhesive layer (A) of the pressure-sensitive adhesive sheet for immobilization of an imprint mold (5) as claimed in any one of claims 1 to 6 to a pressure application unit and bonding an imprint mold to the pressure-sensitive adhesive layer (B) of the pressure-sensitive adhesive sheet for immobilization of an imprint mold.

10. A method for removing an imprint mold (5) from an imprint apparatus, comprising peeling off the pressure-sensitive adhesive layer (A) of the pressure-sensitive adhesive sheet for immobilization of an imprint mold as claimed in any one of claims 1 to 6 from a pressure application unit.

**Patentansprüche**

1. Druckempfindliche Klebefolie zur Immobilisierung einer Imprint-Form (5), die eine druckempfindliche Klebefolie ist, die zum integralen Immobilisieren einer Imprint-Form (5) auf einer Druckbeaufschlagungseinheit in einer Imprint-Vorrichtung verwendet wird, um ein Profil eines feinen Musters, das auf der Imprint-Form (5) gebildet ist, auf einen Transferaufnahmekörper zu übertragen, indem die Imprint-Form, die das feine Muster darauf aufweist, gegen den Transferaufnahmekörper gepresst wird,
wobei die druckempfindliche Klebefolie ein Substrat (3), eine an einer Fläche des Substrats (3) bereitgestellte druckempfindliche Klebeschicht (A) (2) und eine an der anderen Fläche des Substrats (3) bereitgestellte druckempfindliche Klebeschicht (B) (4) aufweist,
wobei die druckempfindliche Klebeschicht (A) für das Verbinden mit der Druckbeaufschlagungseinheit der Imprint-Vorrichtung verwendet wird und die druckempfindliche Klebeschicht (B) für das Verbinden mit der Imprint-Form (5) verwendet wird,
wobei die Klebkraft der druckempfindlichen Klebeschicht (B) bei 23 °C höher als die Klebkraft der druckempfindlichen Klebeschicht (A) bei 23 °C ist, und
die druckempfindliche Klebeschicht (A) eine Klebkraft von 1 bis 10 N/25 mm bei 23 °C und eine Klebkraft von 1 bis 30 N/25 mm aufweist, nachdem ihr erlaubt war, 7 Stunden bei 80 °C und 65 % Luftfeuchtigkeit zu stehen, und die druckempfindliche Klebeschicht (B) eine Klebkraft von 3 bis 30 N/25 mm bei 23 °C aufweist, wobei die Klebkraft bei 23 °C und die Klebkraft nach dem 7 Stunden langen Lassen bei 80 °C und 65 % Luftfeuchtigkeit mit einem Zugwinkel von 90° und einer Abzugsgeschwindigkeit von 300 mm/min gemäß JIS Z0237 gemessen wurden,
wobei die druckempfindliche Klebefolie mindestens eine der folgenden Anforderungen (1) - (5) erfüllt:

(1) die druckempfindliche Klebeschicht (B) enthält ein Lichtabsorptionsmittel und/oder einen Lichtstabilisator,
(2) das gewichtsgemittelte Molekulargewicht des Polymers, das den druckempfindlichen Klebstoff in der druckempfindlichen Klebeschicht (A) darstellt, beträgt 800.000 bis 1.800.000,
(3) der druckempfindliche Klebstoff in der druckempfindlichen Klebeschicht (A) ist ein Copolymer auf Acryl/Silikon-Basis, das durch das Copolymerisieren von Monomeren erhalten wird, die 0,5 bis 20 Gewichtsanteile eines silikonhaltigen Monomers auf der Grundlage von 100 Gewichtsanteilen aller Monomere enthalten,
(4) der Gelanteil der druckempfindlichen Klebeschicht (A) beträgt 70 bis 95 %, und
(5) die druckempfindliche Klebeschicht (A) enthält 1 bis 20 Gewichtsanteile Silikonöl auf der Grundlage von 100 Gewichtsanteilen des druckempfindlichen Klebstoffs.

2. Druckempfindliche Klebefolie zur Immobilisierung einer Imprint-Form nach Anspruch 1, die zur Verwendung in einer Imprint-Vorrichtung vorgesehen ist, wobei der beaufschlagte Druck auf die Imprint-Form während des Imprints 0,1 bis 50 MPa beträgt.

3.  Druckempfindliche Klebefolie zur Immobilisierung einer Imprint-Form nach Anspruch 1 oder 2, die zur Verwendung in einer Imprint-Vorrichtung vom Rollentyp vorgesehen ist.

4.  Druckempfindliche Klebefolie zur Immobilisierung einer Imprint-Form nach einem der Ansprüche 1 bis 3, die für das integrale Immobilisieren einer Imprint-Form, die ein darauf gebildetes Muster in der Nanometer-Größenordnung aufweist auf der Druckbeaufschlagungseinheit vorgesehen ist.

5.  Druckempfindliche Klebefolie zur Immobilisierung einer Imprint-Form nach einem der Ansprüche 1 bis 4, wobei die Klebkraft eines druckempfindlichen Klebstoffs in der druckempfindlichen Klebeschicht (A) 1 bis 10 N/25 mm beträgt.

6.  Druckempfindliche Klebefolie zur Immobilisierung einer Imprint-Form nach Anspruch 5, wobei der druckempfindliche Klebstoff in der druckempfindlichen Klebeschicht (A) ein Acryl-Copolymer ist, das durch das Copolymerisieren eines (Meth)acryl-Monomers und eines Monomers erhalten wird, das eine vernetzende funktionelle Gruppe aufweist.

7.  Imprint-Vorrichtung zum Übertragen eines Profils eines feinen Musters, das auf einer Imprint-Form (5) gebildet ist, auf einen Transferaufnahmekörper durch Pressen der Imprint-Form (5), die das feine Muster darauf aufweist, gegen den Transferaufnahmekörper, wobei:

    wenn die Imprint-Form (5), die mit dem Transferaufnahmekörper in direkten Kontakt tritt, integral auf einer Druckbeaufschlagungseinheit, auf der ein Druck beaufschlagt wird, mit der druckempfindlichen Klebefolie zur Immobilisierung einer Imprint-Form nach einem der Ansprüche 1 bis 6 immobilisiert ist, die druckempfindliche Klebeschicht (B) auf der Seite der Imprint-Form des Substrats der druckempfindlichen Klebefolie angeordnet ist und die druckempfindliche Klebeschicht (A) auf der Seite der Druckbeaufschlagungseinheit des Substrats davon angeordnet ist.

8.  Imprint-Vorrichtung nach Anspruch 7, wobei die Druckbeaufschlagungseinheit eine Druckbeaufschlagungseinheit vom Rollentyp ist.

9.  Verfahren zum Immobilisieren einer Imprint-Form (5) auf einer Imprint-Vorrichtung, umfassend Verbinden der druckempfindlichen Klebeschicht (A) der druckempfindlichen Klebefolie zur Immobilisierung einer Imprint-Form (5) nach einem der Ansprüche 1 bis 6 mit einer Druckbeaufschlagungseinheit, und Verbinden einer Imprint-Form mit der druckempfindlichen Klebeschicht (B) der druckempfindlichen Klebefolie zur Immobilisierung einer Imprint-Form.

10. Verfahren zum Entfernen einer Imprint-Form (5) von einer Imprint-Vorrichtung, umfassend Abziehen der druckempfindlichen Klebeschicht (A) der druckempfindlichen Klebefolie zur Immobilisierung einer Imprint-Form nach einem der Ansprüche 1 bis 6 von einer Druckbeaufschlagungseinheit.

## Revendications

1.  Feuille adhésive sensible à la pression pour l'immobilisation d'un moule d'impression (5), qui est une feuille adhésive sensible à la pression utilisée pour immobiliser solidairement un moule d'impression (5) contre une unité d'application de pression dans un appareil d'impression pour transférer un profil d'un motif fin formé sur le moule d'impression (5) à un corps de réception de transfert par pression du moule d'impression sur lequel se trouve le motif fin contre le corps de réception de transfert,
    ladite feuille adhésive sensible à la pression ayant un substrat (3), une couche adhésive sensible à la pression (A) (2) fournie sur une première surface du substrat (3) et une couche adhésive sensible à la pression (B) (4) fournie sur l'autre surface du substrat (3),
    dans laquelle la couche adhésive sensible à la pression (A) est utilisée pour être liée à l'unité d'application de pression de l'appareil d'impression, et la couche adhésive sensible à la pression (B) est utilisée pour être liée au moule d'impression (5),
    la résistance d'adhérence de la couche adhésive sensible à la pression (B) à 23 °C est supérieure à la résistance d'adhérence de la couche adhésive sensible à la pression (A) à 23 °C, et
    la couche adhésive sensible à la pression (A) a une résistance d'adhérence de 1 à 10 N/25 mm à 23 °C et une résistance d'adhérence de 1 à 30 N/25 mm après avoir reposé pendant 7 heures à 80 °C et à une humidité de 65%, et la couche adhésive sensible à la pression (B) a une résistance d'adhérence de 3 à 30 N/25 mm à 23 °C, dans laquelle la résistance d'adhérence à 23 °C et la résistance d'adhérence après 7 heures à 80 °C et à une humidité de 65 % ont été mesurées à un angle de traction de 90° et une vitesse de pelage de 300 mm/min conformément à JIS Z0237,

dans laquelle ladite feuille adhésive sensible à la pression satisfait au moins à l'une des exigences (1) à (5) suivantes :

(1) la couche adhésive sensible à la pression (B) contient un absorbeur de lumière et/ou un stabilisateur de lumière,

(2) le poids moléculaire moyen en poids du polymère constituant l'adhésif autocollant dans la couche adhésive sensible à la pression (A) est de 800 000 à 1 800 000,

(3) l'adhésif sensible à la pression dans la couche adhésive sensible à la pression (A) est un copolymère à base d'acrylique/silicone obtenu par copolymérisation de monomères contenant de 0,5 à 20 parties en poids d'un monomère contenant de la silicone sur la base de 100 parties en poids de la totalité des monomères,

(4) la fraction de gel de la couche adhésive sensible à la pression (A) est de 70 à 95 %, et

(5) la couche adhésive sensible à la pression (A) contient de 1 à 20 parties en poids d'huile de silicone sur la base de 100 parties en poids de l'adhésif sensible à la pression.

2. Feuille adhésive sensible à la pression pour l'immobilisation d'un moule d'impression selon la revendication 1, qui est destinée à être utilisée dans un appareil d'impression dans lequel la pression appliquée au moule d'impression durant l'impression est de 0,1 à 50 MPa.

3. Feuille adhésive sensible à la pression pour l'immobilisation d'un moule d'impression selon la revendication 1 ou 2, qui est destinée à être utilisée dans un appareil d'impression de type à rouleau.

4. Feuille adhésive sensible à la pression pour l'immobilisation d'un moule d'impression selon l'une quelconque des revendications 1 à 3, qui est pour l'immobilisation solidaire d'un moule d'impression sur lequel est formé un motif d'une taille de l'ordre du nanomètre contre l'unité d'application de pression.

5. Feuille adhésive sensible à la pression pour l'immobilisation d'un moule d'impression selon l'une quelconque des revendications 1 à 4, dans laquelle la résistance d'adhérence d'un adhésif sensible à la pression dans la couche adhésive sensible à la pression (A) est de 1 à 10 N/25 mm.

6. Feuille adhésive sensible à la pression pour l'immobilisation d'un moule d'impression selon la revendication 5, dans laquelle l'adhésif sensible à la pression dans la couche adhésive sensible à la pression (A) est un copolymère acrylique obtenu par copolymérisation d'un monomère (méth)acrylique et d'un monomère ayant un groupe fonctionnel de réticulation.

7. Appareil d'impression pour transférer un profil d'un motif fin formé sur un moule d'impression (5) à un corps de réception de transfert par pression du moule d'impression (5) sur lequel se trouve le profil fin contre le corps de réception de transfert, dans lequel :

lorsque le moule d'impression (5) qui vient en contact direct avec le corps de réception de transfert est solidairement immobilisé contre une unité d'application de pression, sur laquelle une pression est appliquée, avec la feuille adhésive sensible à la pression pour l'immobilisation d'un moule d'impression selon l'une quelconque des revendications 1 à 6, la couche adhésive sensible à la pression (B) est positionnée sur le côté moule d'impression du substrat de la feuille adhésive sensible à la pression, et la couche adhésive sensible à la pression (A) est positionnée sur le côté unité d'application de pression de son substrat.

8. Appareil d'impression selon la revendication 7, dans lequel l'unité d'application de pression est une unité d'application de pression de type à rouleau.

9. Procédé d'immobilisation d'un moule d'impression (5) contre un appareil d'impression, comprenant la liaison de la couche adhésive sensible à la pression (A) de la feuille adhésive sensible à la pression pour l'immobilisation d'un moule d'impression (5) selon l'une quelconque des revendications 1 à 6 contre une unité d'application de pression et la liaison d'un moule d'impression à la couche adhésive sensible à la pression (B) de la feuille adhésive sensible à la pression pour l'immobilisation d'un moule d'impression.

10. Procédé de retrait d'un moule d'impression (5) à partir d'un appareil d'impression, comprenant l'enlèvement par pelage de la couche adhésive sensible à la pression (A) de la feuille adhésive sensible à la pression pour l'immobilisation d'un moule d'impression selon l'une quelconque des revendications 1 à 6 par l'intermédiaire d'une unité d'application de pression.

Figure 1

**EP 2 752 867 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011001520 A
- WO 0017284 A1
- US 6398892 B1
- US 2004241434 A1